# EUROPÄISCHE PATENTSCHRIFT

(11) **EP 1 478 218 B1**
(45) Veröffentlichungstag und Bekanntmachung des Hinweises auf die Patenterteilung: **24.10.2018**
(21) Anmeldenummer: 04011551.1
(22) Anmeldetag: 14.05.2004
(51) Int. Cl.: H05K 7/14

(54) **Sockelbaugruppe für einen Antriebsregler**
Base assembly for drive controller
Base avec composants pour une commande

(30) Priorität: 16.05.2003 DE 10322196
(43) Veröffentlichungstag der Anmeldung: 17.11.2004
(73) Patentinhaber: Lenze Automation GmbH, 40667 Meerbusch (DE)
(72) Erfinder: Hübner, Karsten, 31855 Aerzen (DE); Beilfuss-Spickmann, Uwe, 31840 Hessisch Oldendorf (DE); Wempe, Andreas, 31855 Aerzen (DE); Visser, Gerhard, 31855 Aerzen (DE); Tolksdorf, Andreas, 31789 Hameln (DE)
(74) Vertreter: Leonhard, Frank Reimund

(56) Entgegenhaltungen:
- EP-A- 0 688 092
- EP-A- 0 994 559
- GB-A- 2 271 679

## Beschreibung

Die Erfindung befasst sich mit einer Sockelbaugruppe (Montagesockel) zur Aufnahme (Montage) eines Umrichters, eines Gleichrichters oder einer solchen Steuerbaugruppe. Die Sockelbaugruppe ist ein Abschnitt eines Frequenzumrichters, der auch einen Elektronikabschnitt besitzt, wobei die beiden Abschnitte über elektrische Steckverbinder mechanische lösbar und elektrisch lösbar kontaktiert sind.

Bei der Montage von Frequenzumrichtern, insbesondere solchen Frequenzumrichtern, welche die beschriebene geteilte Funktionalität besitzen, ist der Montageaufwand bei der Erstmontage und eine Wechselzeit bei Austausch einer Sockelbaugruppe zu verbessern. Außerdem soll eine elektrische Kontaktbildung verbessert werden, den der Schirm einer zum Antrieb führenden Leitung gegenüber der Sockelbaugruppe besitzt.

Eine Sockelbaugruppe wird in einem Schaltschrank zumeist an einer metallischen Halteplatte (meist Montageplatte oder Schaltschrankplatte genannt) montiert. Weil der Hersteller der Sockelbaugruppe meist nicht der Hersteller des Schaltschrankes ist, wird die Sockelbaugruppe (und damit auch der zur Sockelbaugruppe gehörende Elektronikabschnitt, bspw. ein Antriebsregler mit Frequenzumrichter) von einem anderen Hersteller geliefert als der Schaltschrank, in den die Sockelbaugruppe eingebaut (festgelegt) sowie elektrisch verbunden werden muss. An der metallischen Halteplatte ist dabei das Anschlagen eines Motorkabels vorgesehen, wobei der Schirm des Motorkabels über diesen an der Halteplatte vorgesehenen Anschlag elektrisch mit der Halteplatte verbunden wird. Damit wird eine elektrisch leitfähige, schirmwirksame Verbindung zu der metallischen Halteplatte hergestellt. Die anderen Leitungen in dem geschirmten Kabel zum Motor werden dann - nach Montage der Sockelbaugruppe an derselben Halteplatte - mit der Sockelbaugruppe über Schraubklemmen verbunden. Nachdem unterschiedliche Hersteller für Schaltschrank und Sockelbaugruppe vorliegen, ggf. sogar das Montieren von noch einem weiteren Unternehmen vorgenommen wird, bestehen oft Schwierigkeiten, die Zuverlässigkeit und die Schirmwirksamkeit der Schirmverbindung des elektrischen Anschlusskabels des Motors sicherzustellen, insbesondere diesen Schirm zuverlässig und wiederholbar mit dem Potential zu verbinden, das auf der Sockelbaugruppe für diesen Schirmanschluss vorgesehen wird.

**Aus** EP 994 559 A2 (SEW) ist auf der Steuerseite (von einem Steuerkopf) eine Kopplung von zwei metallischen Platten bekannt, die für eine Masseverbindung flächig aufeinander montiert werden (dort 23,51,35a).

Die Erfindung hat es sich zur **technischen Aufgabe** (Problemstellung) gemacht, den Schirm der Motorleitung zuverlässiger und reproduzierbarer mit den zugehörigen (potentialgleichen) elektrischen Bereichen auf der Sockelbaugruppe zu verbinden, gleichwohl eine Austauschbarkeit der Sockelbaugruppe zu gewährleisten und eine Erstmontage zu beschleunigen.

Gelöst wird diese Problemstellung mit Anspruch 1 oder Anspruch 20.

Bei der Lösung spielt ein leitfähiges Metallblech eine elektrisch leitende Verbindungsrolle, die es zwischen der Sockelbaugruppe und der metallischen Halteplatte des Schaltschrankes ausübt. Anders als im Stand der Technik wird der Schirm des Motors nicht am Schaltschrank und direkt an der metallischen Halteplatte des Schaltschranks montiert, sondern unmittelbar an der Sockelbaugruppe selbst. Hier findet eine Verbindung des Schirmbereichs des Kabels in elektrisch leitender Hinsicht und in mechanisch fixierender Hinsicht statt, wobei das Metallblech auf der Motor-Ausgangsseite der Sockelbaugruppe mit diesem Schirm nach der mechanischen Montage elektrisch leitfähig in Verbindung steht. Wird die Sockelbaugruppe anschließend durch anderweitige Schraubstellen an der metallischen Halteplatte festgelegt, so ergibt die Verbindung des nach unten zur Halteplatte weisenden Metallblechs mit der metallischen Halteplatte eine schirmwirksame, elektrisch leitfähige Verbindung.

Diese schirmwirksame Verbindung wird durch den gewählten Montageweg zunächst auf das Potential der Sockelbaugruppe gebracht. Dann wird dieses Potential - bei montierter Sockelbaugruppe - mit demjenigen Potential elektrisch gleichgeschaltet, welches auf der metallischen Halteplatte liegt. Die metallische Halteplatte als solches ist nicht Gegenstand und beschränkender Bestandteil des Anspruchs 1, sondern nur Zweckverwirklichung, um definieren zu können, welche Funktion, Aufgabe und welche Ausbildung das metallische Flächenstück (das Metallblech) auf der Motor-Ausgangsseite der Sockelbaugruppe, ausgerichtet zur zukünftigen Montagestelle, besitzt.

Dieses Metallblech (Anspruch 1) entspricht dem metallischen Flächenstück (Anspruch 20), welches unterseitig an der Kombination aus Elektronikabschnitt und Sockelabschnitt angeordnet ist, um es zur Oberseite hin elektrisch mit dem Schirmanschluss der Motorleitung verbinden zu können, und es gemäß Anspruch 20 zum Schaltschrank hin (zur metallischen Halteplatte) elektrisch leitfähig und schirmwirksam verbunden wird. Dies bei der mechanischen Festlegung der Sockelbaugruppe an der Halteplatte.

Damit ist die Erstmontage im Schaltschrank zuverlässig so realisiert, dass eine elektrische Verbindung von Schirm und Schirmpotential auf der Sockelbaugruppe nicht von anderen fremden Einflüssen bei der Montage verändert werden, auf die der Hersteller der Sockelbaugruppe keinen Einfluss hat. Ist beispielsweise der Anschlag (die Anbringungsstelle) für das Motorkabel (die geschirente Motorleitüng) direkt auf der metallischen Halteplatte von nicht deterministischen Einflüssen verändert, so wirkt sich das auf die Zuverlässigkeit der Potentialgleichheit dieses Potentials mit demjenigen Potential aus, das für den Schirm auf der Sockelbaugruppe vorgesehen ist.

Erfindungsgemäß wird der Zwischenabschnitt zwischen der Anschlagstelle auf der metallischen Halteplatte im Schaltschrank und der Verbindungsstelle des Sockelabschnitt zu derselben metallischen Halteplatte ausgeschlossen. Demzufolge auch sein Einfluss auf die Qualität des Schirm"anschlagens".

Die Sockelbaugruppe selbst trägt keine wesentlichen elektronischen Bauteile, sondern nur solche Bauelemente, die im Wesentlichen passive Bauteile sind (Anspruch 5). Für diese passiven Bauteile wird eine Höhenerstreckung benötigt und diese Höhenerstreckung wird als "erste Ebene" definiert. In dieser physikalischen Verbindungsebene sind auch Steckverbinder vorgesehen, von denen zumindest einige eine Steckrichtung senkrecht zur Längs- und Quererstreckung der Verbindungsebene aufweisen. Diese Steckverbinder dienen zur Aufnahme von entsprechenden Gegenverbindern, welche auf dem Elektronikabschnitt zum Sockelabschnitt weisend angeordnet sind. Es wird damit eine mechanisch lösbare, aber elektrisch zuverlässige Verbindung geschaffen. Bei einem Lösen der mechanischen Steckverbindung wird gleichzeitig die elektrische Steckverbindung gelöst, wobei ein Einstecken ebenfalls die elektrische Kontaktierung neben der mechanischen Festlegung sicherstellt.

Die "Verbindungsebene" liegt im montierten Zustand mit ihrer Längs- und Quererstreckung parallel zur elektrischen leitfähigen, metallischen Halteplatte. Nachdem der Sockelabschnitt bzw. die Sockelbaugruppe aber als solches beansprucht ist, ist sie als eine eigene Ebene definiert, die dann im montierten Zustand erst parallel zu dieser elektrisch leitfähigen Halteplatte zu liegen kommt. Die Verbindungsebene dient auch als Montageebene (Montageraüm), wobei sie eine Montagefläche besitzt, die an ihrer Unterseite angeordnet ist und in der das leitfähige Blech bzw. das metallische Flächenstück angeordnet ist, um mit der metallischen Halteplatte verbunden zu werden.

Das Metallblech ist in seiner Ausbildung in Höhenrichtung unkritisch. Es weist zumindest abschnittsweise in Längs- und Querrichtung der Sockelbaugruppe und ist elektrisch leitend mit der Anschlagstelle für den Schirm der zumindest einphasigen Leitung (die zum Motor führt) verbunden (Anspruch 3, Anspruch 4). Das Metallblech bzw. das metallische Flächenstück kann in Querrichtung im Wesentlichen die gesamte Breite der Sockelbaugruppe einnehmen (Anspruch 10). In Längsrichtung kann sich das metallische Flächenstück bis in einen Bereich erstrecken, in dem die Steckverbinder für die Steuerbaugruppe (den Elektronikabschnitt) angeordnet sind (Anspruch 7, Anspruch 9). Das metallische Flächenstück muss dabei nicht entlang seiner gesamten Längserstreckung plan bzw. eben ausgebildet sein, sondern kann wesentliche Abschnitte aufweisen, welche plan ausgebildet zu einer flächigen Kontaktierung und zu einer schirmwirksamen elektrisch leitfähigen Verbindung mit der beschriebenen metallischen Halteplatte geeignet sind. Dazwischen können Aufwölbungen vorgesehen sein, die zur Aufnahme von Schraubstellen ausgeformt sind, z.B. so, dass die elektrische Verbindung der Anschlagstelle des Schirms über die Schraubstelle in das metallische Flächenstück vorgenommen wird (Anspruchs 4).

Ist die Sockelbaugruppe in Längserstreckung über einen wesentlichen Abschnitt als eine Platine ausgeführt, so kann sich eine Teilüberlappung von Platine und metallischem Flächenstück ergeben (Anspruch 9). Die Platine wird sich dabei nicht bis vollständig hin zur elektrischen Anschlagstelle der geschirmten Motorleitung erstrecken, sondern Raum lassen für eine elektrische Kopplung des Schirm zum metallischen Flächenstück, trägt aber Anschlussklemmen, um die Strom führenden Phasen mit den Leiterbahnen auf der Platine verbinden zu können.

Das metallische Flächenstück kann auch selbst, über die Platine in Längsrichtung der Sockelbaugruppe hinausragend, den Anschluss (die Anschlagstelle) für das Motorkabel und seine Schirmung selbst (mechanisch) tragen.

Zur Verbesserung der mechanischen Stabilität der Sockelbaugruppe wird für den Fall des Vorsehens einer Platine ein Kunststoffträger zwischen dem Metallblech (dem metallischen Flächenstück) und der Platine angeordnet. Er erstreckt sich bis zum anderen Ende der Längserstreckung der Sockelbaugruppe (Anspruch 11). Erstreckt sich das Metallblech nicht bis in diesen Bereich, so übernimmt der Kunststoffträger die Aufgabe der Montagefläche ab dem Ende des metallischen Flächenstücks. Die zur metallischen Halteplatte weisende Fläche sollte dabei bevorzugt eben sein (Anspruch 12).

Die Sockelbaugruppe kann lang und schmal ausgebildet (Anspruch 13), wobei sie in Längserstreckung zwischen einer Eingangsseite für Starkstrom oder Netzspannung und einer Ausgangsseite für die vom Frequenzumrichter abgegebene Spannung liegt (Anspruch 13).

Das Metallblech kann neben der schirmwirksamen elektrischen Verbindung von Sockelbaugruppe und metallischer Halteplatte (beispielsweise im Schaltschrank) auch eine Verbindung der PE (Erdleitung) übernehmen. Dazu sind bevorzugt zwei Kontaktstellen, insbesondere Schraubstellen, vorgesehen, welche von der Anschlagstelle des Kabels die elektrische Kopplung und von der Platine die elektrische Kopplung zu dem Metallblech vornehmen, das über eine weitere Schraubstelle mit der elektrischen Halteplatte elektrisch verbunden wird.

Dann bestehen mehrere elektrische Verbindungen von praktisch gleichem Potential, aber verschiedenen sicherheitstechnischen Vorgaben: Die flächige elektrische Verbindung, welche als schirmwirksame Verbindung zwischen der Sockelbaugruppe und dem Montageort vorgesehen ist, und die erdungsgeeignete Verbindung der metallischen Halteplatte mit dem selben Ort, aber eher punktuell und weniger flächig (Anspruch 15, Anspruch 16 oder Anspruch 17).

Die Übertragung des Potentials des Schirms von der Motorleitung geschieht auf einer großen Fläche an der Anschlussklemme, welche den Schirm flächig berührend aufnimmt und zusammen mit dem Ende des Kabels unter Krafteinfluss hält. Da die Anschlussklemme selbst auch zumindest teilweise, vorzugsweise aber flächig metallisch ausgebildet ist, wird das Potential des Schirms flächig auf das Metallblech oder das metallische Flächenstück übertragen, welches an dem Sockelabschnitt nach unten weisend angeordnet ist. Von diese Fläche kann und wird der Schirmanschluss flächig auch auf die metallische (leitende) Halteplatte (Montageplatte) gekoppelt, was eine vollständig großflächige Kopplung des schirmwirksamen Anschlusses des Motorkabels selbst dann erreicht, wenn zusätzlich Schraubverbindungen vorgesehen sind, mit denen die Sockelbaugruppe auf der Montageplatte gehalten ist. Anders als im Stand der Technik, wo Schirme und schirmwirksame Verbindungen im Zuge ihrer Potentialführung zumindest eine Engstelle aufweisen, sei es durch Zusammendrehen des flächigen Schirmes oder sei es durch eine Schraubklemme, welche es erfordert, den Schirm an seinem Ende zu einem runden Stück zu formen, um ihn mit der Schraubklemme erfassen zu können, wird mit der Erfindung erstmals vom Motorkabel ausgehend bis hin zur Montageplatte eine durchgehend großflächige Schirmverbindung geschaffen, welche es ermöglicht, besonders leistungsfähig ein Schirmpotential zu übertragen. Die drei Stufen seien nochmals herausgestellt. Es wird großflächig vom Schirm des Motorkabels auf die Klemme, es wird von hier im Rahmen der metallischen Klemme großflächig auf die metallische Fläche der Sockelbaugruppe übertragen und es wird durch die Ausbildung dieser metallischen Fläche ebenfalls großflächig auf die Montageplatte übertragen, so dass drei Abschnitte entstehen, von denen keine eine starke Einschnürung der Erstreckung einer flächig besonders wirksamen Schirmverbindung erzwingt. Der Begriff der großflächigen Übertragung (Anspruch 19) ist so zu verstehen, dass keine Engstellen im Sinne von Einschnürungen vorhanden sind, wie solche Engstellen, die bei Einsatz von Klemmleisten auch für Schirmanschlüsse zwingend erforderlich wären. Die Erfindung kommt ohne solche Anschlussklemmen im schirmwirksamen Erdungspfad aus.

Die Platte bildet ein gemeinsames Potential großer Fläche, auf der sowohl das Potential des Schirms als auch das Potential der PE liegt, übertragen durch einen Schraubverbinder auf die Halteplatte und übertragen durch einen weiteren Schraubverbinder auf eine ggf. vorgesehene Platine mit entsprechenden Leiterbahnen. Auf dieser Platine kann zusätzlich eine unterbrechbare Brücke als IT-Kopplung vorgesehen sein (isolated terra), welche es erlaubt, EMV-Komponenten einerseits auf der Platine und andererseits auf dem gesteckten Elektronikabschnitt von der Erdung abzutrennen und nicht mit dem genannten Potential zu verbinden. Davon unabhängig ist der Schirmanschluss. Obwohl das Schirmpotential und das PE-Potential dasselbe sein sollten, ist ihre Leitungsführung und ihre Zweckorientierung anders, so dass andere Arten von geometrischen Ausbildungen notwendig sind. Über eine gemeinsame Schraubstelle wird Schirmpotential und PE-Potential auf die Platine mit den Leiterbahnen übertragen, ausgehend von dem großflächigen Metallblech an der Unterseite der Montage- und Verbindungsebene. Nach Übertragung durch die Schraubstelle verzweigt sich die Leitungsführung auf der Platine. Ein Zweig geht über die auftrennbare Brücke als PE-Potential hin zu EMV-Bauteilen sowohl auf der Platine als auch über die Steckerleiste zum Elektronikabschnitt. Der Schirm ist ein weiterer Zweig, der nicht durch eine Brücke unterbrechbar ist, sondern direkt auf die Sockelleiste des Steckverbinders geführt wird, von wo sie zur Leistungsplatine führt.

Unbeeinflusst von dem durchgehenden Schirmanschluss kann somit ein IT-Betrieb des Frequenzumrichters ermöglicht werden. Bei diesem werden die EMV-Komponenten von dem PE-Potential abgetrennt (durch die auftrennbare Brücke), während unabhängig davon der Schirmanschluss bestehen bleibt, obwohl beide gemeinsam über eine Schraubstelle von dem metallischen Flächenstück auf die mit Leiterbahnen versehene Platine gelegt sind.

Soweit bei der obigen Beschreibung eine "metallische Halteplatte" als Bestandteil eines Schaltschranks beschrieben war, der als Montageort für die Sockelbaugruppe vorgesehen ist, ist das nicht die einzige Möglichkeit, die beanspruchte Sockelbaugruppe an einem Montageort zu befestigen. Auch andere Montageorte sind möglich, die nicht Schaltschränke sind, lediglich elektrisch leitfähig sollten sie zumindest in demjenigen Abschnitt sein, der vom metallischen Flächenstück auf der Unterseite der Sockelbaugruppe eingenommen wird.

Eine elektrische Verbindung der Steuerbaugruppe, die über die Steckverbinder mit der Sockelbaugruppe verbunden wird, erfolgt über zumindest einen Kontakt dieses Steckverbinders (Anspruchs 18). Für eine effektive und kostengünstige Realisierung empfiehlt sich die Verwendung von handelsüblichen Steckverbindern, die eine Reihe von Kontaktelementen aufweisen (Anspruch 6). Geschaffen werden dabei elektrisch trennbare Kontaktstellen zwischen der Sockelbaugruppe und der Steuerbaugruppe.

Die elektrische Trennbarkeit der Steckverbinder ist vergleichbar mit der mechanischen Trennbarkeit, so dass die Steuerbaugruppe leicht ausgetauscht werden kann. Muss - was wesentlich seltener ist - auch die Sockelbaugruppe ausgetauscht werden, wird ein solcher Austausch in der Regel begonnen mit dem Lösen der Anschlagstelle des Verbindungskabels zum Motor. Ein Austauschen der Sockelbaugruppe erlaubt es nach ihrer Montage an dem Montageort, das Motorkabel erneut zuverlässig und schirmwirksam mit der Anschlagstelle auf der neuen Sockelbaugruppe zu verbinden, ohne dass Fremdeinflüsse auf die Zuverlässigkeit der elektrischen Verbindung zwischen der Anschlagstelle und der später wieder aufgesteckten Steuerbaugruppe zu befürchten sind.

Ausführungs**beispiele** erläutern und ergänzen die beschriebene und beanspruchte Erfindung.

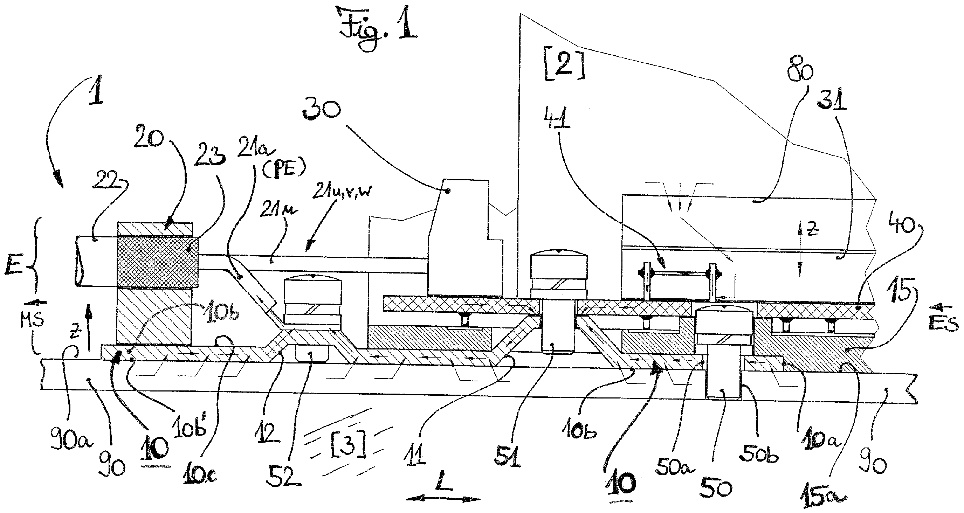

- **Figur 1**: veranschaulicht einen motorseitigen Endabschnitt eines ersten Ausführungsbeispiels der Erfindung, wobei der übrige Bereich der langgestreckten Steuerbaugruppe hier nicht dargestellt ist.

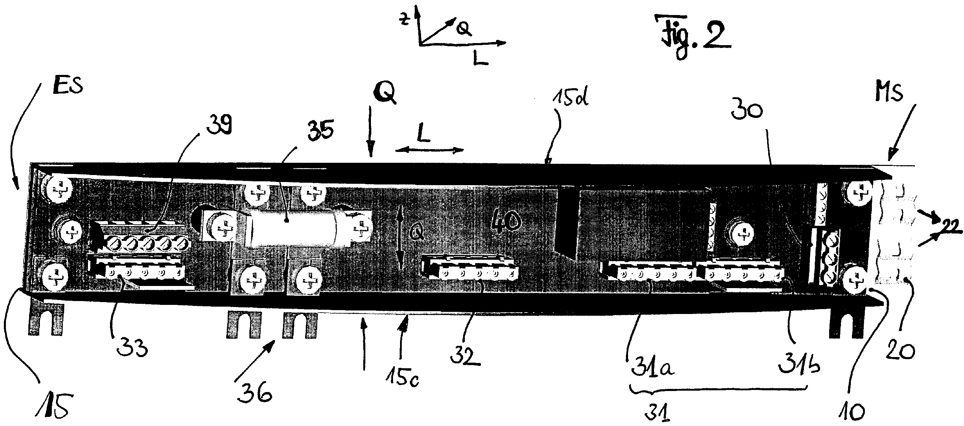

- **Figur 2**: veranschaulicht ein weiteres Ausführungsbeispiel der Erfindung, bei dem die Längserstreckung der Steuerbaugruppe in Aufsicht ersichtlich ist. Hier ist der motorseitige Endabschnitt MS rechts dargestellt, während die Eingangsseite ES zur Aufnahme des Starkstroms und der Starkstrom-Verbinder 39 links dargestellt sind. Entsprechend sind Längserstreckung L und Quererstreckung Q bemessen, senkrecht dazu ist die Aufsteckrichtung z eines hier nicht näher dargestellten, aber in Figur 1 schematisch sichtbaren Leistungsteils als Steuerbaugruppe 2.

**Figur 1** veranschaulicht ein erstes Ausführungsbeispiel, in dem der motorseitige Endabschnitt MS einer Sockelbaugruppe gezeigt ist, welche allgemein mit 1 bezeichnet ist. Eine Steuerbaugruppe, welche elektronische Komponenten, wie Leistungsschalter, Regelungs- und Steuerungsfunktionen sowie Signalgeber für diese Bereiche enthalten kann, ist allgemein mit 2 bezeichnet und über Steckkontakte 80/31 mit der Sockelbaugruppe 1 verbunden. Eine erste Steckkontaktgruppe 80 ist auf der Leistungsplatine der Steuerbaugruppe 2 angeordnet. Eine dazu korrespondierende zweite Steckkontaktgruppe 31 ist auf einer Platine 40 der Sockelbaugruppe angeordnet. Die Steckkontakte sind in vertikaler Richtung z voneinander trennbar, wobei sowohl die mechanische Trennung erfolgt, wie auch die elektrische Trennung. Die Steckerleiste und die Sockelleiste 80 bzw. 31 sind handelsüblicher Natur und weisen in der Regel mehrere in Reihe angeordnete Kontaktstifte bzw. Kontaktaufnahmen auf, die zueinander korrespondieren.

In dem zweiten Ausführungsbeispiel der **Figur 2** ist in Aufsicht die gesamte Steuerbaugruppe von der Bauteilseite aus zu sehen. Hier ist die Motorseite MS am rechten Rand und die Eingangsseite ES am linken Rand dargestellt. In Längserstreckung L einer schmal ausgebildeten Hauptplatine 40 sind mehrere Steckverbinder 33,32 und 31a,31b (gemeinsam als 31 bezeichnet) zu sehen, in die entsprechende Kontaktstifte von oberen Teilen entsprechend dem Steckverbinder 80 eingreifen, wenn die Steuerbaugruppe 11 stirnseitig auf die in Figur 2 sichtbare Sockelbaugruppe aufgesteckt wird und dabei die elektrischen Kontakte hergestellt werden.

Eingangsseitig ES wird Starkstrom zugeführt, meist als dreiphasiges Signal, und Anschlussklemmen 39 sind entsprechend dafür vorgesehen. Auf der Motorseite MS ist eine metallische oder abschnittsweise elektrisch leitfähige Anschlagstelle (im Sinne einer Montagestelle) für ein geschirmtes Kabel 22 vorgesehen, welche in Aufsicht in **Figur 2** und in Schnittdarstellung in Figur 1 zu erkennen ist. Das Kabel 22 ist in Figur 1 eingelegt und angeschlagen, an dem Anschluss 20, wobei ein Schirm 23 elektrisch an dieser Stelle kontaktiert wird. Die übrigen Leitungen, welche der Schirm 23 im Motorkabel 22 umgibt, sind aufgelegt und verbinden sich zu einer Schraubklemme 30 mit beispielsweise drei Phasen, und einem Erdanschluss, der durch eine Schraube 52 repräsentiert sein kann, aber gesondert verläuft. Der Erdanschluss führt über eine eigene Kontaktstelle 52 zu einer metallischen Platte 10, die am motorseitigen Ende 10 auf der Unterseite der Steuerbaugruppe angeordnet ist.

Die Montageebene ist sinngemäß eine funktionell zu betrachtende (physikalische) Ebene, hat aber eine Vertikalerstreckung, welche die Höhe der Sockelbaugruppe 1 ist. Diese Vertikalerstreckung nimmt verschiedene passive Bauteile auf, welche als Sicherung 35, Anschlussklemmen 39,30 und die beschriebenen Steckkontakte 31,32,33 beschrieben werden können. Zusätzlich sind Funkentstörbauteile und Stromschienenabschnitte in dieser funktionell zu sehenden Ebene angebracht, welche Bauteile bildlich in Figur 2 ohne weiteres dem Fachmann ersichtlich sind und deshalb nicht weiter beschrieben werden sollen. Lediglich die Abschnitte der Stromschienen sollen Erwähnung finden, welche dem Zwischenkreis zuzuordnen sind. Diese Abschnitte 36 werden zwischen benachbarten Sockelbaugruppen, wenn mehrere parallel montiert sind, als elektrische Verbindungsstellen eingesetzt.

Die metallische Platte 10 hat mehrere Abschnitte in Längsrichtung L und erstreckt sich im wesentlichen auf der gesamten Breite Q der schmal ausgebildeten Steuerbaugruppe. An drei Stellen sind Schraubstellen angeordnet, die in Längsrichtung beabstandet sind. Eine der Schraubstellen dient zur Aufnahme der Schraube 52 und zur Festlegung von PE (als Erdleitung 21a des Motorkabels 22). Eine weitere Schraubstelle mit der Schraube 51 dient zur Übertragung des PE-Potentials von der Platine 40 bzw. der Leistungsplatine der Steuerbaugruppe 2 auf das Metallblech 10, wie in Figur 1 ersichtlich. Schließlich ist eine weitere elektrische Verbindung weiter in Richtung zum Steckverbinder 31/80 vorgesehen, welche eine elektrische Kontaktierung des metallischen Blechs 10 durch die Schraube 50 vornimmt, und zwar an der Halteplatte 90, an welcher die Sockelbaugruppe in der Figur 1 montiert ist.

Die metallische Platte 10, welche in **Figur 2** an der Rückseite im rechten Randbereich der Sockelbaugruppe angeordnet ist, ist im Schnitt in Figur 1 an den Schraubstellen nach oben aufgewölbt und oben entsprechend abgeflacht, so dass Schrauben mechanisch fixiert und elektrisch leitend kontaktiert werden können. Die erste Erhebung 12 zur Aufnahme der Schraube 52 ist niedriger als die zweite Erhebung 11, die gleichzeitig als Auflage für die Platine 40 dient, wenn die Schraube 51 die Platine hier hinsichtlich ihrer Leiterbahn elektrisch durchkontaktiert und mechanisch positioniert. Im Bereich der dritten Schraube 50 zur Durchkontaktierung des Potentials der elektrisch leitfähigen Metallplatte 10 durch eine Öffnung 50a auf die elektrisch leitfähige Halteplatte 90 ist keine Erhebung vorgesehen.

Im Anschluss an das innere Ende 10a der metallischen Platte 10 ist ein Kunststoffträger 15 vorgesehen, der zumindest flächig sich erstreckend die Unterseite der Sockelbaugruppe bildet und mit seiner unteren Oberfläche 15a auf der nach oben weisenden Oberfläche 90a der metallischen Halteplatte 90 im montierten Zustand zu liegen kommt. Die untere Oberfläche 15a des Kunststoffträgers und die wesentlichen Anteile der unteren Oberfläche der metallischen Halteplatte 10 sind auf einer Ebene liegend ausgebildet, so dass ein gleichmäßiger, satter und anliegender flächiger Kontakt zur Halte-Oberfläche 90a gegeben ist. Der Kunststoffträger 15 ist in dem Bereich, in welchem die metallische Platte 10 vorgesehen ist, ausgenommen oder nach oben verlagert, um weitere Stützungsfunktionen und ggf. Isolierungsfunktionen vornehmen zu können, bspw. als erhabenen Stützring um die Schraubstelle (und den Kopf der Schraube 50) zum mechanischen Stützen der Platine 40 in diesem Bereich. Gleichzeitig kann dieser Kunststoffträger Isolierfunktionen für die auf der Unterseite der Sockelplatine 40 vorgesehenen Lötstellen dienen, die in der Figur 1 ohne nähere Bezugszeichen klar ersichtlich sind. Eine dieser Lötstellen ist unterhalb der Schraubklemme 30 zur elektrischen Kontaktierung der Einzeladern 21u, 21v und 21w, während die PE Einzelader 21a auf das Potential der metallischen Halteplatte durch die erste Schraube 52 gebracht wird.

Diese Schraube 52 ist auch in Figur 2 nahe dem motorseitigen Ende der Sockelplatine 40 rechts vor den Schraubklemmen 30 zu ersehen. Es ist hier anzumerken, dass die schirmwirksame Verbindung schon durch die Anschlagsstelle 20 zu der metallischen Platte 10 hindurchkontaktiert sein kann, was im äußeren Bereich 10b der metallischen Platte geschehen kann. Eine Erdverbindung aber muß zuverlässiger sein, so dass sie über eine gesonderte Schraubverbindung 52 mit einer gesonderten Ader 21a bewerkstelligt ist, aber potentialmäßig auf demselben Potential der metallischen Platte 10 liegt. Die schirmwirksame Verbindung von der metallischen Platte 10 ist im Bereich 10b und auch in ihren übrigen Flachbereichen elektrisch kontaktierend zur metallischen Oberfläche 90a vorgesehen, was durch kleine Pfeile in der Figur 1 repräsentiert ist. Hier sind Erdströme und Ströme des Schirms gezeichnet, die sich im Betrieb ergeben können.

Die Erhebungen in der metallischen Platte zur Anbringung von zwei der drei Schraubverbindungen sind mit 12 und 11 bezeichnet. Die Oberseite der metallischen Platte, die am äußeren Ende frei liegt, trägt die Anschlagstelle 20 als elektrischen Anschluss für den Schirmleiter 23. die Sockelplatine 40 erstreckt sich nicht in diesen Bereich, sondern endet vorher, hier bevorzugt in einem Bereich vor der ersten Schraubstelle 52. Die Sockelplatine 40 erstreckt sich aber in den Bereich der zweiten Schraubstelle 51, um sie hier mechanisch zu positionieren und elektrisch durchkontaktieren zu können.

Es versteht sich, dass nicht zwingend drei Einzeladern für den hochfrequenten Ausgangsstrom des Umrichters vorgesehen sein müssen, sondern auch eine einzelne Ader als Ausgang vorgesehen sein kann, wie auch jede beliebige andere mehrphasige Klemme 30 realisiert werden kann, mit einem entsprechenden mehrphasigen Motorkabel 22, bei allerdings gleich bleibendem Schirm 23.

Am unteren Ende der funktionell zu sehenden Montage- und Verbindungsebene E liegt die Oberfläche 10b' der metallischen Platte 10 zur Schaffung eines elektrisch leitfähigen, zumindest schirmwirksamen Kontakts bzw. einer solchen Verbindung zu der metallischen Halteplatte 90. Die erdungs-geeignete Verbindung wird durch die Erdungsader 21a, die Schraubstelle 52 und die punktuelle Erdungsverbindung über die weitere Schraubstelle 50, die weiter innen liegt, erreicht. Sie ist durch eine Öffnung 50a in eine Aufnahme 50b der Halteplatte 90 eingeschraubt und kann damit neben elektrischem Kontakt auch eine mechanische Verbindung sicherstellen, mit dem Aufbringen einer mechanischen Spannung, welche außerdem die flächige Kontaktierung der Oberflächen 10b' und 90a sicherstellt, zumindest für die schirm-wirksame elektrische Kontaktierung.

Die flächige Kontaktierung ist besonders vorteilhaft für eine schirmwirksame Kopplung von der Sockelbaugruppe zur Montageplatte 90. Praktisch durchgehend ist ein großflächig leitender Übergang vom Motorleitüng 22 über dessen Schirmanschluss 23 zur Anschlagstelle (Schirmauflage des Kabelschirms auf dem Schirmblech) gegeben, welcher Anschluss 20 entweder ganz oder zumindest großflächig metallisch (elektrisch leitend) zu der metallischen Platte 10 führt, die selbst die flächige Kontaktierung an der Montageplatte ermöglicht. Eigenständig führt aber auch die flächige Metallplatte 10 dasselbe Potential, auf welche das PE-Potential als Einzelader aus dem Motorleitung 22 herausgeführt ist, zu einer Schraubstelle 51, die sowohl Schirmpotential als auch Erdpotential gemeinsam auf die höhere Lage der Sockelplatine 40 führt, von wo sie über Leiterbahnen weiter verzweigt werden. Eine Zweigstelle ist vorgesehen, die nicht in Aufsicht an der Figur 1 ersichtlich ist, aber in ihrer Funktion und Bahnführung erläutert werden soll.

Ein Zweig der Aufgabelung dieses Potentials führt über eine auftrennbare Drahtbrücke 41, die als IT-Brücke anzusehen ist. Ist sie geschlossen, sind EMV-Komponenten auf der Platine 40 und EMV-Komponenten auf der Leistungsplatine 2 (hier über die Steckerleiste 80,31) mit dem Erdpotential verbunden. Wird diese Brücke aufgetrennt, ist ein IT-Betrieb möglich (isolated terra), ohne dass die EMV-Komponenten mit dem Erdpotential verbunden sind.

Ein zweiter Zweig führt eigenständig nicht über die auftrennbare Brücke, sondern direkt in die Sockelleiste 31 und zumindest einen dort befindlichen gesonderten Steckkontakt auf die Leistungsplatine und stellt den Schirmanschluss her. Schirm und PE werden somit in der metallischen Platte 10 auf gemeinsamem Potential geführt, auch physisch gemeinsam, und über eine gemeinsame Schraubstelle 51 auf die Platine gelegt. Hier zweigen sie auseinander und gehen eigenständige Wege. Der Schirmanschluss ist ununterbrechbar (bei eingesteckter Leistungsplatine). Der Erdanschluss PE ist über die IT-Brücke 41 unterbrechbar.

Die Haltplatte 90 ist als metallisch beschrieben. Sie ist elektrisch leitfähig und wird im gezeigten Bereich der Figur 1 auch vollständig metallisch ausgebildet. Nachdem der hier symbolisch dargestellte Schaltschrank 3, dessen weitere Ausmaße und Aufbauten nicht näher dargestellt sind, nur ein Beispiel eines möglichen Anbringungsortes ist, ist die Halteplatte 90 auch nur symbolisch erläutert, um die elektrischen Verbindungen und den montierten Zustand zu veranschaulichen. Es ist jeder Montageort möglich, soweit zumindest im Bereich der metallischen Platte 10 als Metallblech, welche auch als Metallblech bezeichnet werden kann, eine flächige elektrische Kontaktierung möglich ist, die zumindest für den Schirm eine schirm-wirksame Erdung zur Verfügung stellt.

Zusammen genommen betrachtet, also mit der Sockelbaugruppe 1 und der Steuerbaugruppe 2 als Elektronikabschnitt entsteht ein vollständiger Antriebsregler, beispielsweise als Umrichter, als nur Gleichrichter oder als gesteuerter Gleich- oder Umrichter, zum Anpassen von Frequenzen zwischen der Eingangsseite ES und der Ausgangsseite MS, wobei nicht nur Frequenzen, sondern auch Spannungen und Ströme von dem Elektronikabschnitt 2 steuernd beeinflusst werden. Fest montiert und einzeln geliefert kann die Basis des Gesamtaufbaus werden, so die Sockelbaugruppe, welche auch zu mehreren nebeneinander aufgereiht an einem Montageort (in der vorhergehenden Beschreibung die Haltplatte 90) durch Schraubverbindungen montiert werden kann. Aufgesteckt durch Steckverbinder wird die Steuerbaugruppe, die selbst leicht austauschbar ist, sofern Wartungsarbeiten durchzuführen sind oder elektrische Probleme auf Ursachen hin untersucht werden sollen. Ein Austauschen des aktiven Leistungsteils (Elektronikabschnitt oder Steuerbaugruppe 2) bleibt möglich. Die elektrischen Kontakte 33,32,31 werden gelöst durch Ziehen in +z-Richtung bzw. werden geschlossen, durch Drücken in -z-Richtung. Zumindest eine Verbindung durch die elektrische Kontaktierung 31/80 sorgt für eine Übertragung des Erdungspotentials der metallischen Halteplatte 10 auch in den Bereich der Leistungsplatine im Elektronikabschnitt 2, wobei aufgrund des Aufbaus sichergestellt ist, dass die Schirmung 23 zuverlässig und wiederholbar genau mit dem Potential auf dem Metallblech 10 verbunden ist und ebenso zuverlässig und störungsfrei dieses Potential auch in den Elektronikbereich übertragen wird. Fremdeinflüsse über Zwischenabschnitte des Schaltschranks oder der Montagefläche 90 scheiden völlig aus.

Die Unterseite der Verbindungs- und Montageebene E ist die Montagefläche, in welcher die Oberfläche 10b' der metallischen Platte 10 liegt, um eine flächige schirm-wirksame Verbindung zum Montageort herzustellen. Diese flächige Übertragung eines Erdungspotentials wird auf der Motorseite vorgenommen, wo aufgrund der auftretenden höheren Frequenzen der Motorzuleitungen 21u, 21v, 21w eine Schirmung sinnvoll, meist sogar gefordert ist.

Ein nicht gezeigtes Ausführungsbeispiel hat an der Figur 1 orientiert eine längere Erstreckung des Metallblechs 10, bevorzugt zu einer größeren Stabilität und Verwindungssteifigkeit der Sockebaugruppe, wobei der Kunststoffträger 15 in seiner Längserstreckung verbleiben kann, nur wesentliche Anteile der Verbindungsfläche zur Haltplatte 90 nicht einnimmt. Sinngemäß entspricht dies einer Verlängerung des inneren Endes 10a von Figur 1 weiter in Richtung der Eingangsseite ES, wie aus Figur 2 ersichtlich.

Ebenso wie die Erstreckung in Längsrichtung erweitert werden kann, kann die Erstreckung des Metallblechs 10 in Querrichtung reduziert werden. In dem Ausführungsbeispiel von Figur 1 war eine Quererstreckung von im wesentlichen der Breite Q der Sockelbaugruppe beschrieben. Diese Breite kann auch reduziert werden, wobei aber zumindest ein flächiger Abschnitt verbleiben sollte, der eine schirmwirksame Erdung durch Flächenkontakt gegenüber der metallischen Halteplatte 90 bewerkstelligen soll.

Ein weiteres nicht dargestelltes, aber ohne weiteres ersichtliches Ausführungsbeispiel liegt darin, die Platine 40 ganz fortfallen zu lassen und mit dem Metallblech 10 in Längs- und Quererstreckung L, Q als Hauptträger die Sockelbaugruppe auszugestalten. Dann würden die entsprechenden Bauteile und Verbindungselemente in der Montageebene E durch Schraubverbindungen auf einem Metallblech montiert, nicht durch Durchkontaktieren und Löten auf einer Platine 40, wie in Figur 1 symbolisch verdeutlicht.

## Patentansprüche

1. Sockelbaugruppe (1) zur Aufnahme eines Umrichters, Gleichrichters oder einer solchen Steuerbaugruppe (2) für eine Umsetzung von Strom und/oder Spannung von einer Starkstrom-Eingangsseite (ES) auf eine steuerbare Motor-Ausgangsseite (MS) für einen Motor, wobei
- die Sockelbaugruppe (1) eine Längserstreckung (L) und eine Quererstreckung (Q) aufweist, welche eine Montage- und Verbindungsebene (E) definieren, deren Unterseite eine Montagefläche bildet, zur mechanischen Montage der Sockelbaugruppe in einem Schaltschrank (3);
- in der Montage- und Verbindungsebene (E) mehrere elektrische Steckverbinder (30,31,32,33,39) vorgesehen sind, von denen zumindest einige eine Steckrichtung senkrecht (z) zur Montage- und Verbindungsebene (E) aufweisen;
- auf der Motor-Ausgangsseite (MS) die Montagefläche von einem Metallblech (10) gebildet ist, das sich in Längs- und Querrichtung erstreckt, wodurch es bei einer Montage der Sockelbaugruppe (1) in dem Schaltschrank (3) mit seiner metallischen Montagefläche (10b') an einer metallischen Halteplatte (90) des Schaltschranks zu liegen kommt und dabei mit dem Metallblech (10) eine elektrisch leitfähige, schirmwirksame Verbindung zu der metallischen Halteplatte (90) bildet; **dadurch gekennzeichnet, dass**
- das Metallblech (10) zumindest einen in der Montage- und Verbindungsebene (E) gelegenen Anschluss (20) als Schirmanschluss für eine geschirmte Leitung (22,23) zum Motor trägt.

2. Sockelbaugruppe (1) nach Anspruch 1, wobei die schirmwirksame Verbindung vom Schirm (23) der abgeschirmten Motorleitung (22,23) großflächig zur metallischen Halteplatte (90) so erfolgt, dass sie keine Engstellen oder starke Einschnürungen hat.

3. Sockelbaugruppe (1) nach Anspruch 2, wobei der Schirmanschluss (20) für eine Aufnahme einer zumindest einphasigen, bevorzugt dreiphasigen Leitung (21u,21v,21w), insbesondere mit einer zusätzlichen Erdleitung (PE,21a) geeignet ist.

4. Sockelbaugruppe (1) nach Anspruch 2 oder 3, wobei der Schirmanschluss (20) den Schirm (23) der geschirmten Leitung - im verbundenen Zustand - elektrisch leitend mit dem Metallblech (10) verbindet, oder eine leitfähige Kopplung zwischen Schirmanschluss (20) und Metallblech (10) besteht.

5. Sockelbaugruppe (1) nach Anspruch 1, wobei die Montage- und Verbindungsebene eine Höhenerstreckung (z) aufweist, und in dieser Ebene als Verbindungsraum passive Bauteile angeordnet sind, wie
Sicherung (35),
Motorklemmen (30),
Funkentstörbauteile,
Stromschienenabschnitte (36), insb. des Zwischenkreises,
Steckverbinder (40) für die Steuerbaugruppe (2).

6. Sockelbaugruppe (1) nach Anspruch 1, wobei die elektrischen Steckverbinder als handelsübliche mechanische Anschlussstecker (40) ausgebildet sind, mit jeweils mehreren elektrischen Kontaktelementen, zur Schaffung von mechanisch lösbaren und elektrisch trennbaren Kontakten mit entsprechenden Kontakt-Gegenstücken (80).

7. Sockelbaugruppe (1) nach Anspruch 1, wobei das Metallblech (10) sich in Längsrichtung bis in einen Bereich erstreckt, in welchem die elektrischen Steckverbinder (40,80) für die Steuerbaugruppe (2) gelegen sind.

8. Sockelbaugruppe (1) nach Anspruch 1, wobei das Metallblech (10) sich im Wesentlichen ganz in Längsrichtung durchgehend bis auf die Eingangsseite (ES) erstreckt und die Montagefläche (10b) mit seiner von der Verbindungsebene (E) abgewandten Seite bildet.

9. Sockelbaugruppe (1) nach Anspruch 1 oder 7, wobei oberhalb des Metallblechs (10) eine Platine (40) angeordnet ist, welche vor dem Anschluss (20) für die geschirmte Motorleitung (22,23) endet, aber das Metallblech ein Stück weit überlappt.

10. Sockelbaugruppe (1) nach einem der vorherigen Ansprüche, wobei das Metallblech (10) im Wesentlichen eine gesamte Breite (Q) der Sockelbaugruppe einnimmt.

11. Sockelbaugruppe (1) nach Anspruch 1 oder 7, wobei zwischen dem Metallblech (10) und der Platine (10,40) ein Kunststoffträger beginnt (15), der sich bis auf die Eingangsseite (ES) erstreckt und die Montagefläche ab dem Ende (10a) des Metallblechs bildet (50a).

12. Sockelbaugruppe (1) nach Anspruch 11, wobei die Montagefläche des Kunststoffträgers (15) und die Montagefläche (10b') des Metallblechs (10) - zur Montagefläche (90a) der Halteplatte weisend - eine durchgehende, ebene Fläche bilden (10b,15a).

13. Sockelbaugruppe (1) nach Anspruch 1, wobei sie schmal ausgebildet ist, insbesondere wesentlich länger (L) als breit (Q) ist.

14. Sockelbaugruppe (1) nach Anspruch 1, wobei im Bereich des Metallblechs (10) zumindest eine weitere Verbindungsstelle (50a) vorgesehen ist, zur elektrisch leitenden Verbindung des Metallblechs (10) über einen Schraubverbinder (50) zu der Haltplatte (90), um eine für eine Erdung (PE) geeignete oder erdungs-geeignete leitfähige Verbindung zu bilden.

15. Sockelbaugruppe (1) nach Anspruch 1 und 9, wobei zwei Schraubverbinder (51,52) vorgesehen sind, welche eine jeweils erdungs-geeignete Verbindung
(i) von einem Schutzleiter (PE) der Motorleitung
(22,21a) zu dem Metallblech (10), und
(ii) von der Platine (40) zum Metallblech (10) herstellen.

16. Sockelbaugruppe (1) nach Anspruch 15 und 14, wobei die zwei Schraubverbinder (51,52) eine elektrische Kontaktierung zum Metallblech (10) bilden, um diese zum Metallblech und über die weitere Schraubstelle (50) erdungs-geeignet mit der Halteplatte (90) zu koppeln.

17. Sockelbaugruppe (1) nach Anspruch 15, wobei die elektrischen Verbindungsstellen (50a,51,52) in Längsrichtung beabstandet angeordnet sind.

18. Sockelbaugruppe (1) nach Anspruch 1, wobei von der Steuerbaugruppe (2) eine schirmwirksame Leitverbindung zu dem Metallblech (10) führt, über zumindest einen der Steckverbinder (31).

19. Sockelbaugruppe (1) nach Anspruch 1, angepasst zur Montage auf der Halteplatte (90), wobei eine großflächig stromleitende Schirmverbindung von dem Anschluss (20) in dessen Bereich zu dem Metallblech (10) vorgesehen ist, insbesondere der Anschluss (20) zumindest teilweise metallisch ist, womit ein anzubringender Schirm (23) durchgehend großflächig mit dem Metallblech (10) verbunden wird, und das Metallblech (10) ausgebildet ist, elektrisch großflächig leitend zur metallischen Halteplatte (90) zu verbinden.

20. **Verfahren zur Montage** eines Frequenzumrichters für einen Motor, der Umrichter mit einem Elektronikabschnitt und einem Sockelabschnitt (1), welche über elektrische Steckverbinder (30,31,32,33,39) mechanisch lösbar und elektrisch lösbar kontaktiert sind, wobei
der Sockelabschnitt (1) zumindest auf einer Motorseite (MS) ein metallisches Flächenstück (10) unterseitig trägt, welches mit einem Anschluss (20) für eine Schirmung (23) einer zum Motor führenden Leitung (22) versehen ist, und das metallische Flächenstück (10) an einem metallischen Haltestück (90) montiert wird.

21. Verfahren nach Anspruch 20, wobei eine Elektronik im Elektronikabschnitt eine Leistungselektronik zur Motorsteuerung umfasst, womit eine Steuerbaugruppe (2) gebildet wird.

22. Verfahren nach Anspruch 20 oder 21, wobei der Sockelabschnitt (1) als langgestreckte Baugruppe ausgebildet wird und in einem Schaltschrank montiert wird, in dem das metallische Haltestück (90) angeordnet ist.

23. Verfahren nach Anspruch 20, wobei der Anschluss (20) für die Schirmung eine mehrphasige Leitung (22), insbesondere eine dreiphasige Leitung, als die zum Motor führende geschirmte Leitung (22,23) aufnimmt, und diese geschirmte Leitung (22,23) am Anschluss (20) montiert wird.

## Claims

1. Base assembly (1) for receipt of a converter, rectifier or such control assembly (2) for a conversion of current and/or voltage from a heavy current input side (ES) to a controllable motor output side (MS) for a motor, wherein
- the base assembly (1) has a length extension (L) and a transversal extension (Q), that define a mounting and connection plane (E), forming at its lower side a mounting surface for a mechanical mounting of the base assembly in a control cabinet (3);
- several electrical plug connectors (30,31,32,33,39) are provided in the mounting and connection plane (E), with at least some of them having a plug direction perpendicular (z) to the mounting and connection plane (E);
- the mounting surface at the motor output side (MS) is formed by a metal sheet (10) extending in length and transversal directions, whereby, when the base assembly (1) is installed in the control cabinet (3), it comes to rest at a metal mounting plate (90) of the control cabinet with its metal mounting surface (10b') and the metal sheet (10) forms an electrically conductive connection with shielding effect to the metal mounting plate (90), **characterized in that**,
- in the mounting and connection plane (E), the metal sheet (10) bears at least one connection (20) as shield connection for a shielded cable (22,23) to the motor.

2. Base assembly (1) according to claim 1, wherein the shield connection of the shield (23) of the shielded motor cable (22,23) is made at large area to the metallic mounting plate (90) in such a way that no narrows or significant constrictions are present.

3. Base assembly (1) according to claim 2, wherein the shield connection (20) is suitable to receive at least a single-phase, preferably three-phase cable (21u,21v,21w), particularly with an additional ground cable (PE,21a).

4. Base assembly (1) according to claim 2 or 3, wherein the shield connection (20) - when connected - electrically conductive connects the shield (23) of the shielded cable with the metal sheet (10) or an electrically conductive connection between shield connection (20) and metal sheet (10) is present.

5. Base assembly (1) according to claim 1, wherein the mounting and connection plane shows a height extension (z) and in this plane, as connective space, passive modules are positioned, such as
fuse (35),
motor terminals (30),
interference suppression components,
bus bar sections (36), particularly of the intermediate circuit,
plug connectors (40) for the control assembly (2).

6. Base assembly (1) according to claim 1, wherein the electric plug connectors are designed as customary mechanical connector plugs (40), each provided with several electric contact elements to create mechanically releasable as well as electrically releasable contacts with corresponding contact counterparts (80).

7. Base assembly (1) according to claim 1, wherein the metal sheet (10) lengthwise extends into an area housing the electrical connector plugs (40,80) for the control assembly (2).

8. Base assembly (1) according to claim 1 wherein the metal sheet (10) substantially completely lengthwise continuously extends to the input side (ES)and forms the mounting surface (10b) with its side facing away from the connection plane (E).

9. Base assembly (1) according to claim 1 or 7, wherein a board (40) is positioned above the metal sheet (10), ending in front of the connector (20) for the shielded motor cable (22,23), with the metal sheet overlapping slightly.

10. Base assembly (1) according to one of the above claims, wherein the metal sheet (10) substantially takes a whole width (Q) of the base assembly.

11. Base assembly (1) according to claim 1 or 7, wherein a plastic carrier begins (15) between metal sheet (10) and the board (10,40), extending to the input side (ES) and forms (50a) the mounting surface from the end (10a) of the metal sheet.

12. Base assembly (1) according to claim 11, wherein the mounting surface of the plastic carrier (15) and mounting surface (10b') of the metal sheet (10) - pointing to the mounting surface (90a) of the mounting plate - form a continuous even surface (10b,15a).

13. Base assembly (1) according to claim 1, wherein it is formed narrowly, especially substantially longer (L) than wide (Q).

14. Base assembly (1) according to claim 1, wherein at least one further connection (50a) is provided in the area of the metal sheet (10) for an electrically conductive connection of the metal sheet (10) to the mounting plate (90) via a screw connector (50) to establish a connection for grounding (PE) or a conductive connection suitable for grounding.

15. Base assembly (1) according to claim 1 and 9, wherein two screw connectors are provided (51, 52), each providing a connection suitable for grounding
(i) from a protective conductor (PE) of the motor cable (22, 21a) to the metal sheet (10) and
(ii) from the board (40) to the metal plate (10).

16. Base assembly (1) according to claim 15 and 14, wherein the two screw connectors (51,52) form an electrical contact to the metal sheet (10) in order to couple them with the metal sheet and via the further screw connector (50) with the mounting plate (90) in such a way that it is suitable for grounding.

17. Base assembly (1) according to claim 15, wherein the electrical connectors (50a,51,52) are arranged lengthwise at a distance from one another.

18. Base assembly (1) according to claim 1, wherein via at least one of the plug connectors (31) an electrical conductive shield connection leads from the control assembly (2) to the metal sheet (10).

19. Base assembly (1) according to claim 1, adapted for installation at the mounting plate (90), wherein a large-area electrical conductive shield connection is provided from the connection (20) in its area to the metal sheet (10), particularly the connection (20) is at least partially made of metal, whereby a shield (23) to be mounted is connected continuously at large-area to the metal sheet (10) and the metal sheet (10) is designed in such a way that it allows large-area electrical connection to the metal plate (90).

20. **Method for mounting** a frequency converter for a motor, the converter comprising an electronics portion and a base portion (1), that are releasably mechanically and releasably electrically connected via electric plug connectors, wherein
the base portion (1) carries a metal sheet (10) underneath on at least a motor side (MS), , comprising a connector (20) for a shielding (23) of a cable (22) leading to the motor and the metal sheet (10) is mounted on a metal holder (90).

21. Method according to claim 20, wherein an electronics in the electronics portion comprises power electronics for motor control, forming a control assembly (2).

22. Method according to claim 20 or 21, wherein the base portion (1) is designed as an elongated assembly and is mounted in a control cabinet, in which the metal holder (90) is positioned.

23. Method according to claim 20, wherein for shielding purposes the connection (20) receives a multiphase cable (22), particularly a three-phase cable, as shield connection leading to the motor (22,23), and this shielded cable (22,23) is mounted at the connection (20).

## Revendications

1. Module de base (1) destiné à recevoir un convertisseur, un redresseur ou un module de commande de ce type (2) pour une conversion de courant et/ou de tension depuis un côté d'entrée de courant fort (ES) à un côté de sortie de moteur réglable (MS) pour un moteur, dans lequel
- le module de base (1) présente une extension longitudinale (L) et une extension transversale (Q), qui définissent un plan de montage et de connexion (E), dont le côté inférieur forme une face de montage, pour le montage mécanique du module de base dans une armoire de distribution (3);
- il est prévu dans le plan de montage et de connexion (E) plusieurs connecteurs à fiches électriques (30, 31, 32, 33, 39), parmi lesquels au moins quelques-uns présentent une direction de connexion perpendiculaire au plan de montage et de connexion (E);
- sur le côté de sortie de moteur (MS), la face de montage est formée par une tôle métallique (10), qui s'étend dans la direction longitudinale et transversale, et vient ainsi en contact avec une plaque de maintien métallique (90) de l'armoire de distribution lors d'un montage du module de base (1) dans l'armoire de distribution (3) avec sa face de montage métallique (10b') et forme en l'occurrence avec la tôle métallique (10) un assemblage blindé électriquement conducteur avec la plaque de maintien métallique (90);
**caractérisé en ce que**
- la tôle métallique (10) porte au moins un raccord (20) situé dans le plan de montage et de connexion (E) comme raccord blindé pour une ligne blindée (22, 23) vers le moteur.

2. Module de base (1) selon la revendication 1, dans lequel l'assemblage blindé du blindage (23) de la ligne blindée du moteur (22, 23) par une grande surface à la plaque de maintien métallique (90) est effectué de telle manière qu'il ne comporte pas de zones étroites ou de forts étranglements.

3. Module de base (1) selon la revendication 2, dans lequel le raccord blindé (20) convient pour recevoir une ligne (21u, 21v, 21w) au moins monophasée, de préférence triphasée, en particulier avec une ligne de terre supplémentaire (PE, 21a).

4. Module de base (1) selon la revendication 2 ou 3, dans lequel le raccord blindé (20) relie le blindage (23) de la ligne blindée - dans l'état raccordé - en liaison électrique à la tôle métallique (10), ou il existe un couplage conducteur entre le raccord blindé (20) et la tôle métallique (10).

5. Module de base (1) selon la revendication 1, dans lequel le plan de montage et de connexion présente une extension en hauteur (z), et des composants passifs sont disposés dans ce plan faisant office de chambre de connexion, comme
un fusible (35),
des bornes du moteur (30),
des composants de déparasitage,
des parties de rails de contact (36), en particulier du circuit intermédiaire,
des connecteurs à fiches (40) pour le module de commande (2).

6. Module de base (1) selon la revendication 1, dans lequel les connecteurs à fiches électriques sont réalisés sous forme de connecteurs de raccordement mécaniques du commerce (40), avec chaque fois plusieurs éléments de contact électriques, pour créer des contacts mécaniquement séparables et électriquement interruptibles avec des éléments de contact opposés correspondants (80).

7. Module de base (1) selon la revendication 1, dans lequel la tôle métallique (10) s'étend en direction longitudinale jusque dans une région dans laquelle sont situés les connecteurs à fiches électriques (40, 80) pour un module de commande (2).

8. Module de base (1) selon la revendication 1, dans lequel la tôle métallique (10) s'étend essentiellement entièrement en direction longitudinale en continu jusque sur le côté d'entrée (ES) et forme la face de montage (10b) avec son côté situé à l'opposé du plan de connexion (E).

9. Module de base (1) selon la revendication 1 ou 7, dans lequel une platine (40) est disposée au-dessus de la tôle métallique (10), et se termine avant le raccord (20) pour la ligne blindée du moteur (22, 23), mais recouvre la tôle métallique un peu plus loin.

10. Module de base (1) selon l'une quelconque des revendications précédentes, dans lequel la tôle métallique (10) occupe essentiellement une largeur totale (Q) du module de base.

11. Module de base (1) selon la revendication 1 ou 7, dans lequel entre la tôle métallique (10) et la platine (10, 40) commence un support en matière plastique (15), qui s'étend jusque sur le côté d'entrée (ES) et forme la face de montage à partir de l'extrémité (10a) de la tôle métallique (50a).

12. Module de base (1) selon la revendication 11, dans lequel la face de montage du support en matière plastique (15) et la face de montage (10b) de la tôle métallique (10) - tournées vers la face de montage (90a) de la plaque de maintien - forment une face plane continue (10b, 15a).

13. Module de base (1) selon la revendication 1, dans lequel il est de forme étroite, en particulier nettement plus long (L) que large (Q).

14. Module de base (1) selon la revendication 1, dans lequel il est prévu dans la région de la tôle métallique (10) au moins un autre point de connexion (50a), pour la connexion électriquement conductrice de la tôle métallique (10) par un connecteur à vis (50) à la plaque de maintien (90), afin de former une connexion conductrice convenant pour la mise à la terre (PE) ou apte à une mise à la terre.

15. Module de base (1) selon la revendication 1 et 9, dans lequel il est prévu deux connecteurs à vis (51, 52), qui établissent une liaison respective apte à une mise à la terre
(i) d'un conducteur de protection (PE) de la ligne du moteur (22, 21a) à la tôle métallique (10), et
(ii) de la platine (40) à la tôle métallique (10).

16. Module de base (1) selon la revendication 15 et 14, dans lequel les deux connecteurs à vis (51, 52) forment une mise en contact électrique avec la tôle métallique (10), afin de coupler celle-ci à la tôle métallique et via l'autre connecteur à vis (50) à la plaque de maintien (90) d'une façon apte à une mise à la terre.

17. Module de base (1) selon la revendication 15, dans lequel les points de connexion électrique (50a, 51, 52) sont disposés de façon espacée en direction longitudinale.

18. Module de base (1) selon la revendication 1, dans lequel une liaison conductrice blindée conduit du module de commande (2) à la tôle métallique (10), via au moins un des connecteurs à fiches (31).

19. Module de base (1) selon la revendication 1, adapté pour le montage sur la plaque de maintien (90), dans lequel il est prévu une liaison blindée conductrice de grande surface depuis le raccord (20) dans la région de celui-ci jusqu'à la tôle métallique (10), en particulier le raccord (20) est au moins en partie métallique, avec lequel un blindage à poser (23) est assemblé de façon continue par une grande surface à la tôle métallique (10), et la tôle métallique (10) est configurée de façon à être assemblée électriquement de façon conductrice par une grande surface à la plaque de maintien (90).

20. Procédé de montage d'un convertisseur de fréquence pour un moteur, le convertisseur comportant une partie électronique et une partie de base (1), qui sont mises en contact de façon mécaniquement séparable et électriquement interruptible par l'intermédiaire de connecteurs à fiches électriques (30, 31, 32, 33, 39), dans lequel la partie de base (1) porte sur son côté inférieur au moins sur le côté du moteur (MS) une pièce plate métallique (10), qui est munie d'un raccord (20) pour un blindage (23) d'une ligne (22) conduisant au moteur, et la pièce plate métallique (10) est montée sur une pièce de maintien métallique (90).

21. Procédé selon la revendication 20, dans lequel une électronique dans la partie électronique comprend une électronique de puissance pour la commande du moteur, avec laquelle on forme un module de commande (2).

22. Procédé selon la revendication 20 ou 21, dans lequel la partie de base (1) est réalisée sous la forme d'un module allongé et est montée dans une armoire de distribution, dans laquelle la pièce de maintien métallique (90) est disposée.

23. Procédé selon la revendication 20, dans lequel le raccord (20) pour le blindage reçoit une ligne polyphasée (22), en particulier une ligne triphasée, en tant que ligne blindée (22, 23) conduisant au moteur, et cette ligne blindée (22, 23) est montée sur le raccord (20).
